# EUROPEAN PATENT APPLICATION

(11) **EP 0 929 150 A1**
(43) Date of publication of application: **14.07.1999**
(21) Application number: 97204146.1
(22) Date of filing: 31.12.1997
(51) Int. Cl.: H03G 3/20

(54) **A method of and a circuit for automatic gain control (AGC)**

(71) Applicant: TELEFONAKTIEBOLAGET L M ERICSSON (publ), 126 25 Stockholm (SE)
(72) Inventor: Van Zeijl, Paulus Thomas Maria, 7559 AD Hengelo (NL)
(74) Representative: Dohmen, Johannes Maria Gerardus

(57) **Abstract**

A method of and a circuit for Automatic Gain Control (AGC) by decreasing the gain if the output signal (11) is above a set signal level (8), such that the output signal (11) is at the set signal level (8) after a first time period (12), and by increasing the gain if the output signal (11) is below the set signal level (8) such that the output signal (11) is at the set signal level (8) after a second time period (13) wherein the first time period (12) is longer than the second time period (13).

## Description

### Field of the Invention

The present invention relates generally to gain control of amplifier circuits and, more specifically, to an Automatic Gain Control (AGC) circuit for use in receiver equipment.

### Background of the Invention

AGC circuits are widely used in receiver equipment for controlling the dynamic range of signals received.

The amplitudes of signals arriving at receiver equipment, in practice, vary due to reflections, scattering, diffraction, attenuation and other distortions at the transmission path. That is, the amplitude of the received signal varies with time.

Those skilled in the art will appreciate that large signal amplitudes cause distortions in the processing circuitry of the receiver equipment, whereas too small signal levels are undesirably influenced by noise generated by the processing circuitry. With an AGC circuit the dynamic range of the signals is limited for further processing thereof.

Usually, the control of an AGC circuit is described by the parameters "attack-time" and "decay-time".

The decay-time is the time period within which a signal from below a set signal level is amplified up to a desired signal level, that is within the range for further processing.

The attack-time is the time period within which a signal above a set signal level is attenuated or less amplified, such to be in the range for further processing.

In conventional AGC circuits, the attack-time is set relatively short, that is the gain of the AGC circuit is reduced very fast. The decay-time is set relatively long, i.e. it takes a long time before the gain of the AGC circuit increases.

In receiver equipment processing FM (Frequency Modulation) like signals, such as in radio communication equipment operating in accordance with the DECT (Digital Enhanced Cordless Telecommunications) and GSM (Global System for Mobile communications) standard or the like, the information is contained in the momentaneous phase or frequency of the received signals.

However, due to multipath interference, the amplitude of the received FM signal may also vary. This amplitude variation has a negative impact on the phase detection for the further processing of the received signal. In order to improve the receiver performance, AGC circuitry may be used.

It has been found that, with the known settings of an AGC circuit, having a relatively fast attack-time and a relatively slow decay-time, in case of digitizing the output signal using an AD (Analog-to-Digital) converter, the signal can be partly lost.

### Summary of the Invention

It is an object of the present invention to provide an improved method of controlling an Automatic Gain Control (AGC) circuit and an AGC circuit operating in accordance with such improved method.

Accordingly, there is provided a method of controlling an Automatic Gain Control (AGC) circuit by decreasing its gain if its output signal is above a set first signal level, such that the output signal is at a set second signal level below the first signal level after a first time period, and by increasing its gain if its output signal is below a set third signal level, such that the output signal is at a set fourth signal level above the third signal level after a second time period, wherein the first time period is longer than the second time period.

Following the invention, if the output signal drops below the lower or minimum third signal level, the gain of the AGC circuit is increased relatively fast, such that the output signal is at the fourth signal level required for further processing thereof without loss of information.

On the other hand, if the output signal is above a set first signal level, the gain of the AGC circuit is relatively slowly decreased. Thereby preventing a decrease of the gain of the AGC circuit on an isolated peak in the output signal, with the risk that after such peak the output signal is at a too low level for further processing without loss of information.

In a preferred embodiment of the method according to the invention, in particular for use with a DECT receiver, assuming that the output signal is an AC (Alternate Current) signal having a particular signal period, the second time period is preferably set below three to five times the signal period of the output signal and/or the first time period is preferably set equal to or above five times the signal period of the output signal.

If the output signal is a frequency varying signal, such as a communication signal received by a communication receiver, the signal period for setting the first and second time periods is preferably associated with the maximum frequency component of the output signal.

In practical AGC circuits, the second and fourth signal levels are substantially equal, whereas the difference between the first and third signal level defines a range wherein the output signal may vary without changing the gain of the AGC circuit. In practice, the first, second, third and fourth signal levels may be equal or substantially equal.

The invention further provides an Automatic Gain Control (AGC) circuit, comprising a Gain Controllable Amplifier (GCA) having input, output and gain control terminals, and a Gain Control Circuit (GCC) having input and output terminals, wherein an input terminal of said GCC operatively connects to either one of the input and output terminals of the GCA and an output terminal of the GCC operatively connects to the gain control terminal of the GCA for controlling the gain of the GCA in response to an input signal level at the input terminal of said GCC, such that if an output signal level of said AGC is above a set first signal level the gain of said GCA is decreased such that the output signal is at a set second signal level below the first signal level after a first time period, and wherein if the output signal of said AGC is below a set third signal level the gain of the GCA is increased such that the output signal is at a fourth signal level above the third signal level after a second time period, wherein the GCC is arranged such that the first time period is longer than the second time period.

The AGC circuit according to the invention can be of the so-called "feed-forward" type, wherein the input terminal of the GCC is connected to the input terminal of the GCA, or of the so-called "feed-back" type, wherein the input terminal of the GCC is connected to the output terminal of the GCA.

In the preferred embodiment of the AGC circuit according to the invention, in particular for use with a DECT receiver, the GCC is arranged such that, if the output signal is an AC signal having a particular signal period, the second time period is below three to five times the signal period of the output signal and/or the first time period is equal to or above five times the signal period of the output signal. With such settings, a minimum loss of information in case of a drop in the output signal level and/or an isolated peak signal level is encountered, respectively. In practice, for frequency varying signals, the signal period for setting the first and second time periods, is the signal period of the maximum frequency component of the output signal.

The invention further provides a receiver circuit, having receiver means comprising a novel and inventive AGC circuit as disclosed above. In a further embodiment, the receiver circuit comprises AD (Analog-to-Digital) converter means following the AGC circuit for use in digital receiver equipment.

The above-mentioned and other features and advantages of the invention are illustrated in the following description with reference to the enclosed drawings.

### Brief Description of the Drawings

Figure 1 shows, in a schematic and illustrative manner an amplitude varying output signal and set signal levels defining a dynamic range of an AGC circuit.
Figure 2a shows, in a schematic and illustrative manner, an input signal of an AGC circuit.
Figure 2b shows, in a schematic and illustrative manner, the output signal of a conventional AGC circuit in response to the input signal of figure 2a.
Figure 2c shows, in a schematic and illustrative manner, the output signal of the AGC circuit according to the invention in response to the input signal of figure 2a.
Figure 3 shows a schematic block diagram of an AGC circuit of the feed-forward type, according to the present invention.
Figure 4 shows a schematic block diagram of an AGC circuit of the feed-back type, according to the present invention.
Figure 5 shows a schematic circuit diagram of a prior art amplitude detector.
Figure 6 shows a schematic block diagram of a radio receiver circuit according to the present invention.

### Detailled Description of the Embodiments

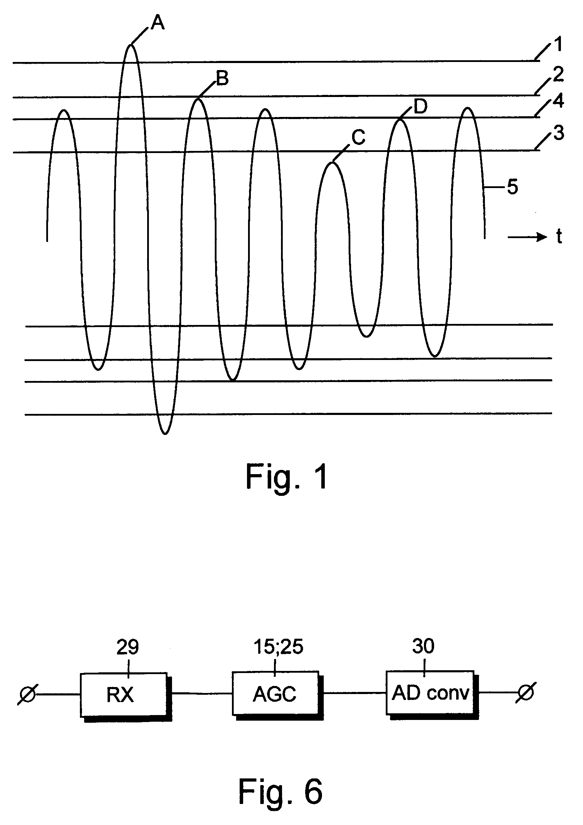

Figure 1 shows a typical time-varying output signal 5 of an Automatic Gain Control (AGC) circuit. Further, four signal levels are defined, that is a first signal level 1, a second signal level 2, a third signal level 3 and a fourth signal level 4, as shown. Because the figure is provided for illustrative purposes only, no particular values have been indicated.

If the amplitude of the signal 5 raises above the first signal level 1, i.e. indicated by "A", the gain of the AGC circuit will be decreased, such that the amplitude of the signal 5 is at the second signal level 2, indicated by "B".

If the amplitude of the output signal 5 drops below the third signal level 3, indicated by "C", the gain of the AGC circuit will be increased, such that the signal amplitude is at the fourth level 4, indicated by "D".

In practice, the amplitude of the output signal 5 varies between the second and fourth signal levels 2, 4, respectively.

For the further explanation of the invention, it is assumed that the first, second, third en fourth signal levels 1, 2, 3, 4 are set to the same level.

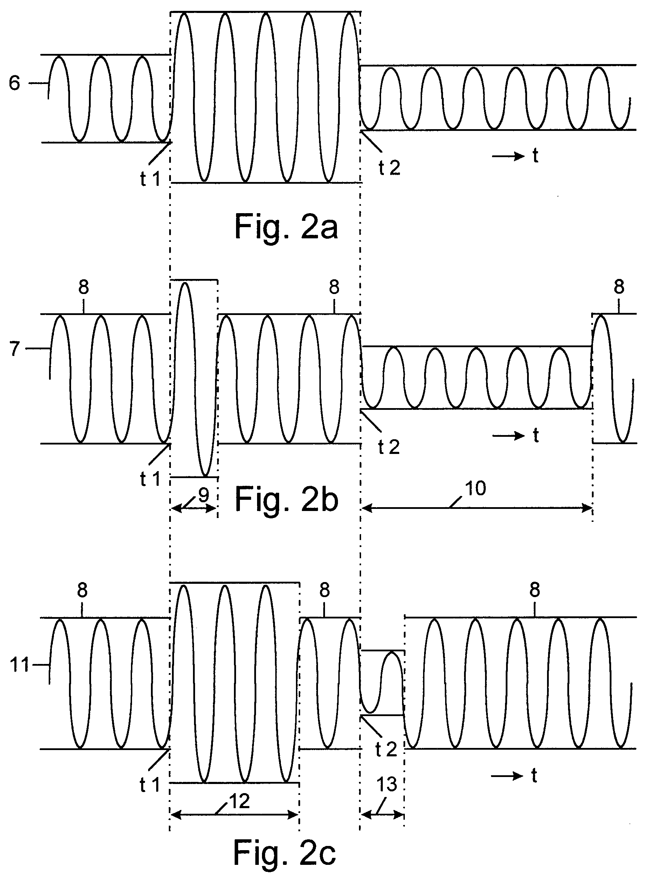

Figure 2a shows a typical input signal 6 of an AGC circuit, wherein at time t1 the signal amplitude increases and at time t2 decreases. Note that the amplitude of the input signal 6 varies relatively fast compared to the frequency or signal period, for reasons of clarity.

Figure 2b shows the output signal 7 of a conventional AGC circuit having a set output level 8 for further processing of the signal 7. Assuming no time delay (ideal AGC circuit) at time t1 the amplitude of the output signal 7 increases due to the increase of the amplitude of the input signal 6. As can be seen from the figure, within one period of the output signal 7, i.e. indicated by reference numeral 9, the gain of the AGC circuit is reduced, such that the output signal is at the set signal level 8. This time period 9 is called the "attack-time".

At time t2 the amplitude of the output signal 7 decreases, due to the decrease of the amplitude of the input signal 6. After about six to seven signal periods, the output signal 7 is again at its set level 8. This time period is called the "decay-time", indicated by a reference numeral 10.

As can be seen from figure 2b, in the example shown, the decay-time is about six to seven times the attack-time.

Figure 2c shows the output signal 11 of the AGC circuit operating in accordance with the present invention.

The increase of the amplitude of the input signal 6 at time t1 causes an increase of the amplitude of the output signal 11. As shown, after about three signal periods, the amplitude is reduced to the set level 8. That is, the attack-time 12 is about three signal periods.

The decrease in the input signal level at time t2 causes a corresponding decrease of the level of the output signal 11, however this decrease is corrected within about one signal period, that is the decay-time 13 is about one signal period.

As can be seen from figure 2c, the decay-time 13 is much faster or shorter than the attack-time 12, following the present invention. The values apply of course to the present example and are of an illustrative nature.

If the output signal of the AGC circuit is digitized, using an AD (Analog-to-Digital) converter, processing signals at the set signal level 8, there is a risk that during the decay-time 10; 13 part of the output signal 7; 11 will be missed, due to its lower amplitude. However, with the settings of the AGC circuit according to the present invention, the output signal 11 is below the set level 8 only for a relatively short time compared to the period of the signal which, in practice, has none or a neglectable influence on the digitized output signal.

In a preferred embodiment of the invention, in particular for use with a DECT (Digital Enhanced Cordless Telecommunications) receiver, the attack-time or first time period is set equal to or above five times the signal period of the output signal, whereas the decay-time 13 or second time period is set below three to five times the signal period of the output signal. With such settings, there is less or no risk of loosing information if the output signal is digitized. In general, if the output signal is a frequency varying signal as in communication receiver equipment, the attack-time and decay-time are set in accordance with the signal period associated with the highest signal frequency.

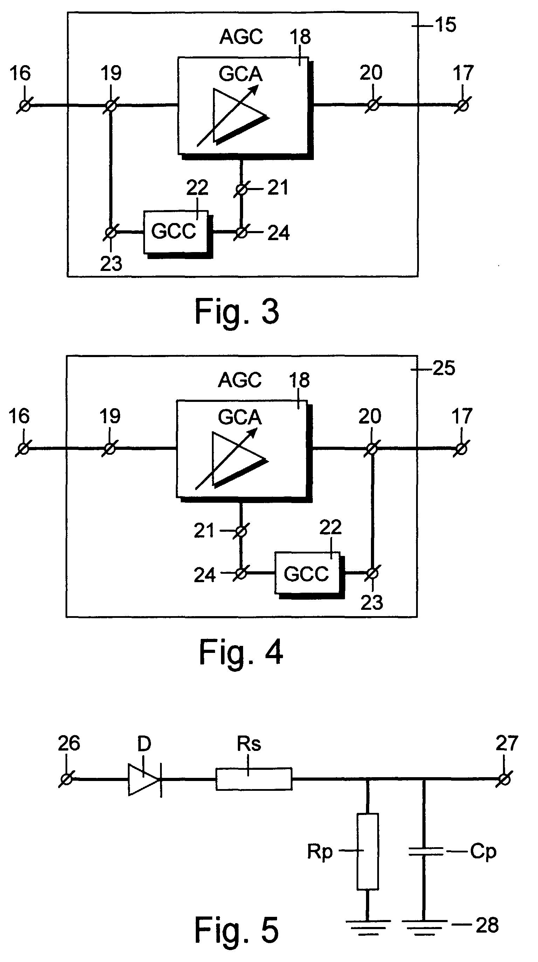

Figure 3 shows an AGC circuit 15 according to the invention of the so-called "feed-forward" type, having an input terminal 16 and an output terminal 17.

The AGC circuit 15 comprises a Gain Controllable Amplifier (GCA) 18 having an input terminal 19, an output terminal 20 and a gain control terminal 21. The AGC circuit 15 further comprises a Gain Control Circuit (GCC) 22 having an input terminal 23 and an output terminal 24.

As shown in figure 3, the input terminal 19 of the GCA 18 is connected to the input terminal 16 of the AGC circuit 15 and the output terminal 20 of the GCA is connected to the output terminal 17 of the AGC circuit. The output terminal 24 of the GCC 22 is connected to the gain control terminal 21 of the GCA, whereas the input terminal 23 of the GCC 22 connects to the input terminal 19 of the GCA 18.

In accordance with the invention, the GCC 22 is arranged such that the attack-time 12 is longer than the decay-time 13 of the AGC circuit 15.

Figure 4 shows an AGC circuit 25 according to the invention of the so-called "feed-back" type. Different from the AGC circuit 15 of figure 3, the input terminal 23 of the GCC 22 is connected to the output terminal 20 of the GCA 18 and the output terminal 24 of the GCC 22 connects to the gain control terminal 21 of the GCA 18. Again, according to the invention, the GCC 22 is arranged such that the attack-time 12 is longer than the decay-time 13 of the output signal at the output terminal 17 of the AGC circuit 25.

Figure 5 shows a circuit diagram of a prior art amplitude detector, comprising an input terminal 26 and output terminal 27. A series connection of a diode D1 and a resistor Rs connects between the input terminal 26 and output terminal 27, as shown. From the output terminal 27 a parallel connection of a resistor Rp and a capacitor Cp connects to signal ground 28. In this circuit, the attack-time is substantially equal

to the value of the series resistor Rs in parallel with the resistor Rp times the capacitor Cp, whereas the decay-time equals the product of the values of the parallel resistor Rp and the capacitor Cp.

Figure 6 shows a block diagram of a radio receiver circuit according to the invention, comprising a cascade connection of RF (Radio Frequency) receiver means RX 29, an AGC circuit 15 or 25 as disclosed above, and an AD converter 30 following the AGC circuit 15; 25. The output signal of the AD converter 30 is further processed by processing circuitry (not shown).

A GCA 18, receiver means 29 and AD converter means 30 are components known to persons skilled in the art, which need no further description. Reference is made to numerous literature on this subject.

Although the invention has been disclosed in connection with RF receiver means, use of the AGC circuit is not limited to radio receiver means, but may also be used for controlling the dynamic range of optical signals and the like.

## Claims

1. A method of controlling an Automatic Gain Control (AGC) circuit by decreasing its gain if its output signal is above a set first signal level, such that said output signal is at a set second signal level below said first signal level after a first time period, and by increasing its gain if its output signal is below a set third signal level, such that said output signal is at a set fourth signal level above said third signal level after a second time period, characterized in that said first time period is longer than said second time period.

2. A method according to claim 1, wherein said output signal is an AC signal having a signal period, and wherein said second time period is below three to five times the signal period of said output signal.

3. A method according to claim 1 or 2, wherein said output signal is an AC signal having a signal period, and wherein said first time period is equal to or above five times the signal period of said output signal.

4. A method according to claim 2 or 3, wherein said output signal is a frequency varying signal and said signal period is the signal period of the maximum frequency component of said output signal.

5. A method according to any of the previous claims, wherein said second and fourth signal levels are substantially equal.

6. A method according to any of the previous claims, wherein said first, second, third and fourth signal levels are substantially equal.

7. An Automatic Gain Control (AGC) circuit, comprising a Gain Controllable Amplifier (GCA) having input, output and gain control terminals, and a Gain Control Circuit (GCC) having input and output terminals, wherein an input terminal of said GCC operatively connects to either one of said input and output terminals of said GCA and an output terminal of said GCC operatively connects to said gain control terminal of said GCA for controlling the gain of said GCA in response to an input signal level at said input terminal of said GCC, such that if an output signal level of said AGC is above a set first signal level the gain of said GCA is decreased such that said output signal is at a set second signal level below said first signal level after a first time period, and wherein if said output signal of said AGC is below a set third signal level the gain of said GCA is increased such that said output signal is at a fourth signal level above said third signal level after a second time period, characterized in that said GCC is arranged such that said first time period is longer than said second time period.

8. An AGC circuit according to claim 7, wherein said output signal is an AC signal having a signal period, and wherein said GCC is arranged such that said second time period is below three to five times the signal period of said output signal.

9. An AGC circuit according to claim 7 or 8, wherein said output signal is an AC signal having a signal period, and wherein said GCC is arranged such that said first time period is equal to or above five times the signal period of said output signal.

10. An AGC circuit according to claim 8 or 9, wherein said output signal is a frequency varying AC signal and said signal period is the signal period of the maximum frequency component of said output signal.

11. An AGC circuit according to claim 7, 8 or 9, wherein said second and fourth signal levels are substantially equal.

12. An AGC circuit according to claim 7, 8 or 9, wherein said first, second, third and fourth signal levels are substantially equal.

13. A receiver circuit, having receiver means comprising an AGC circuit according to any of the claims 7-12.

14. A receiver circuit according to claim 13, comprising AD (Analog-to-Digital) converter means following said AGC circuit.
